(19) Europäisches Patentamt

European Patent Office

Office européen des brevets

(11) Veröffentlichungsnummer: **0 537 632 A2**

# (12) EUROPÄISCHE PATENTANMELDUNG

(21) Anmeldenummer: **92117244.1**

(22) Anmeldetag: **09.10.92**

(51) Int. Cl.⁵: **H03M 11/20**

(30) Priorität: **17.10.91 DE 4134358**

(43) Veröffentlichungstag der Anmeldung:
**21.04.93 Patentblatt 93/16**

(84) Benannte Vertragsstaaten:
**AT BE CH DE DK ES FR GB IT LI NL SE**

(71) Anmelder: **Alcatel SEL Aktiengesellschaft**
**Lorenzstrasse 10**
**W-7000 Stuttgart 40(DE)**

(72) Erfinder: **Käuffert, Uwe Werner**
**Im Steinacker 7**
**W-7530 Pforzheim(DE)**

(74) Vertreter: **Knecht, Ulrich Karl et al**
**Alcatel SEL AG, Patent- und Lizenzwesen,**
**Postfach 30 09 29**
**W-7000 Stuttgart 30 (DE)**

(54) **Schaltungseinrichtung zur Abfrage einer Tastatur.**

㊗ Beschrieben wird eine Schaltungseinrichtung zur Abfrage einer Tastatur (1), die als Matrix in Form von Reihen und Spalten aufgebaut ist, und bei der die Reihen nacheinander mit einem Signal angesteuert werden, das bei gedrückter Taste (T) an der zugehörigen Spalte ein Signal hervorruft, und bei der je Ansteuerung einer Reihe alle Spalten nacheinander abgefragt werden. Dabei wird der Ausgang ($L_{40}$) eines Zählers (40), der zyklisch bis zu einem bestimmten Zählerstand zählt, in einem Demultiplexer (30) derart umgesetzt, daß zeitlich aufeinanderfolgend im Takt des Zählers eine bestimmte Anzahl (m + n) Signale zur Abfrage von Reihen der Matrix generiert werden. Ein Teil (m) dieser Signale wird stets zur Ansteuerung einer gleichen Zahl von Reihen der Matrix verwendet ($L_{30}, L_{10}$). Von den weiteren im Demultiplexer (30) generierten Signalen können eine wählbar beliebige Zahl (1,2, ... (n-1)) über entsprechend einstellbare Abschnitte (201,202, ..., 208) eines Multiplexers (20) ebenfalls zur Ansteuerungen von Reihen der Matrix verwendet ($L_{31}, L_{20}$) werden. Über die verbleibenden Abschnitte des Multiplexers (20), die nicht zur Ansteuerung von Reihen der Matrix geschaltet sind, werden die Spalten der Matrix an einen weiteren Multiplexer (50) durchgeschaltet ($L_{20}, L_{21}$), der, ebenfalls von Signalen am Ausgang ($L_{41}$) des Zählers (40) gesteuert, während des Anliegens eines Abfragesignals an einer Reihe nacheinander im Takt des Zählers (40) die durchgeschalteten Spalten der Matrix abfragt.

FIG.1

Die Erfindung betrifft eine Schaltungsanordnung zur Abfrage einer Tastatur, die als Matrix in Form von Reihen und Spalten aufgebaut ist, und bei der die Reihen nacheinander mit einem Signal angesteuert werden, das bei gedrückter Taste an der zugehörigen Spalte ein Signal hervorruft, und bei der je Ansteuerung einer Reihe alle Spalten nacheinander abgefragt werden.

Der Erfindung liegt die Aufgabe zugrunde, eine Schaltungsanordnung anzugeben, die in einfacher Weise an verschiedene Matrixkonfigurationen einer Tastatur angepaßt werden kann.

Aus **IBM-Technical-Disclosure-Bulletin Vol. 27 No. 5, Oktober 1984 S. 2779/2780** ist eine Schaltungsanordnung bekannt, bei der ein Mikroprozessor die Abfrage einer Tastatur so steuert, daR in einem bestimmten Zeitpunkt lediglich eine Treiberleitung als Ausgang und gleichzeitig alle anderen als Eingänge konfiguriert sind, um Schäden in Folge von Kurzschlüssen der Treiberleitungen bei gleichzeitigem Drücken von zwei Tasten zu eleminieren.

Aus **U. Tietze / Ch. Schenk, Halbleiter-Schaltungstechnik (4. Aufl., 1978)** ist die Abfrage einer Tastatur im Multiplexverfahren bekannt geworden, bei dem man bei einem 4 mal 4 Tastenfeld vier Anschlüße als Ausgänge für die Zeilenleitungen und vier Anschlüße als Eingänge für die Spaltenleitungen verwendet.

Aus der **DE-PS 36 41 527 C1** ist eine Schaltungsanordnung zur Abfrage einer Kontaktmatrix durch einen Rechner bekannt geworden, bei der der Rechner nach Betätigung mindestens einer Taste aktiviert wird und eine Abfragezyklus durchführt. In den Zeilen- und Spaltenzuleitungen der Matrix sind Umschaltmittel vorgesehen, die bei nicht betätigter Matrix die parallele Anschaltung einer Prüfungspannung an sämtliche Matrixelemente und erst nach Abgabe eines Umschalt-Steuersignals durch den Rechner den spaltenweisen Anschluß eines Abfragepotentials und den Zugriff des Rechners zu den Zeilenleitungen bewirken.

Anregungen zur Anpassung einer Schaltungseinrichtung, die zur Abfrage einer als Matrix aufgebauten Tastatur dient, an verschiedene Matrixkonfigurationen und zur einfachen Erhöhung der Zahl der abfragbaren Tasten über die Zahl der Tasten hinaus, die in durch eine bestimmte Tastatur vorgegeben ist, sind diesen Druckschriften nicht zu entnehmen.

Erfindungsgemäß wird die genannte Aufgabe dadurch gelöst, daß der Ausgang eines Zählers, der zyklisch bis zu einem bestimmten Zählerstand zählt, in einem Demutiplexer derart umgesetzt wird, daS zeitlich aufeinanderfolgend im Takt des Zählers eine bestimmte Anzahl Signale zur Abfrage von Reihen der Matrix generiert werden, daß ein Teil dieser Signale stets zur Ansteuerung einer gleichen Zahl von Reihen verwendet wird, daß von den weiteren im Demultiplexer generierten Signale in wählbar beliebiger Zahl über entsprechend einstellbare Abschnitte eines Multiplexers ebenfalls zur Ansteuerung von Reihen der Matrix verwendet werden, und daß über die verbleibenden Abschnitte des Multiplexers, die nicht zur Ansteuerung von Reihen der Matrix verwendet werden, die Spalten der Matrix an einen weiteren Multiplexer durchgeschaltet werden, der, ebenfalls von Signalen am Ausgang des Zählers gesteuert, während des Anliegens eines Abfragesingals an einer Reihe, nacheinander im Takt des Zählers die durchgeschalteten Spalten der Matrix abfragt.

Man kann also bspw., ausgehend von einer Grundmatrix m x n (im Beispiel: 8 mal 8) durch entsprechende Ansteuerung des Multiplexers Matrixkonfigurationen bis zu (m + n-1) mal 1 ansteuern, indem zusätzlich zu den m Reihen der Grundmatrix noch weitere (n-1) Reihen über dem Multiplexer angesteuert werden. Steuert man also z.B. zusätzlich r Reihen über den Multiplexer an, so verbleiben bei einer Grundmatrix m x n dann (n-r) Spalten. Man kann also die Konfiguration der abzufragenden Matrix dadurch ändern, daß die Zahl der Reihen erhöht und die Zahl der Spalten erniedrigt wird. Bei einer Grundmatrix von z.B. 8 mal 8 (m = 8; n = 8) kann man also die Matrixkonfiguration einfach auf 9 mal 7, 10 mal 6, usw. bis hin zu 15 mal 1 Matrix umsetzen. Eine einfache jedoch sehr vorteilhafte Weiterbildung der Erfindung erlaubt eine externe Expandierung der gegebenen Konfigurationsmöglichkeiten bis hin zu einer Matrix der Form $2^{(m-1)}$ mal n, also bei m = 8, n = 8 (Grundmatrix 8 mal 8) bis zu einer Matrix der Form $2^7$ mal 8, = 128 mal 8 = 1024, d.h. mit 1024 Tasten.

Bei einer Grundmatrix m x n muß der Zähler mindestens bis m x n zählen (also bei einer 8 x 8 Matrix 64). Um die Expandierung zu ermöglichen, zählt der Zähler jedoch bis zu einem höheren Zählerstand, maximal jedoch bis $2^{(m-1)}$ mal n (im Beispiel also bis 1024). Die maximale Matrix ist damit $2^{(m-1)}$ x n. Liegt der maximale Zählerstand zwischen m x n und $2^{(m-1)}$ x n, dann ist die die Zahl der Tasten, die im expandierten Modus, abgefragt werden kann, entsprechend niedriger.

Ein Ausführungsbeispiel der Erfindung und ihrer vorteilhaften Weiterbildungen wird im folgenden unter Bezugnahme auf die beigefügten Zeichnungen beschrieben. Es stellen dar:

Figur 1
das Ausführungsbeispiel;
Figur 2
den Multiplexer 20.
Figuren 3a und 3b
zwei Einstellungen bei einer Ausführung mittels programmierbaren Mikroprozessor.

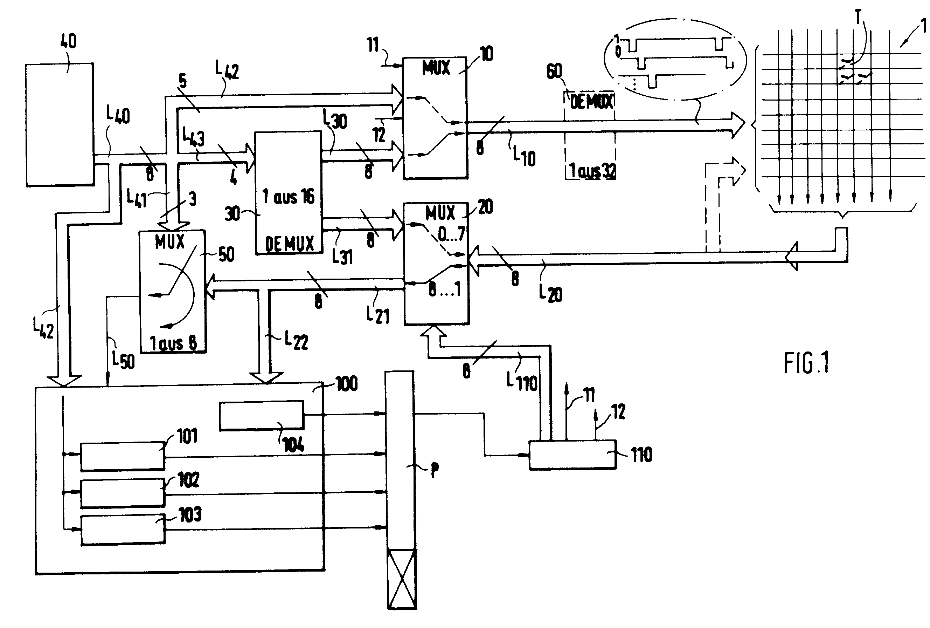

Die Schaltungseinrichtung nach Figur 1 weist eine Tastatur 1 auf, die als Matrix mit acht Spalten und acht Reihen aufgebaut ist. Diese 8 mal 8 Matrix wird im folgenden als Grund-Matrix bezeichnet. An den Kreuzungspunkten sind Tasten T vorgesehen. Sie sind allerdings nur an wenigen Kreuzungspunkten eingezeichnet, um die Übersichtlichkeit der Darstellung nicht zu beeinträchtigen. Sie befinden sich aber an allen Kreuzungspunkten. Zur Abfrage der Tastatur, d.h. Festellung, ob irgendeine Taste T geschloßen sind, werden nacheinander, wie durch die Kurvenläufe links oberhalb der Tastatur 1 angedeutet, die verschiedenen Reihen abgefragt, indem das Potential der jeweils abgefragten Reihe von z.B. 1 auf 0 gelegt wird. Ist eine Taste T geschloßen, so wird die zugehörige Spalte, die über einem Widerstand mit Potential 1 verbunden ist, ebenfalls auf dieses Potential ($=0$) gezogen. Dies ergibt dann an der Spalte in dem Zeitpunkt, in dem die betreffende Reihe abgefragt wird, ein Ausgangssignal 0. Daraus läßt sich dann durch Zuordnung der gerade abgefragten Reihe zu der Spalte, an der dann dieses Ausgangssignal auftritt, die Taste T feststellen, die geschlossen ist. Da im Beispiel eine 8 mal 8 Matrix vorgesehen ist, sind acht Leitungen $L_{10}$ den Reihen der Matrix als Eingänge in die Matrix und die acht Leitungen $L_{20}$ den Spalten der Matrix als Ausgänge aus der Matrix zugeordnet.

Das Signal zur Abfrage der Reihen der Matrix, die die Tastatur 1 bildet, wird wie folgt vorgenommen: Der Zähler 40 zählt von 1 bis 256 ($= 2^8$). Der Zählerstand ist auf den acht Leitungen $L_{40}$ dargestellt. Vier dieser Leitungen, die mit $L_{43}$ bezeichnet sind, gelangen an den Demultiplexer 30. Auf den vier Leitungen $L_{43}$ sind also die Zählerstände 1 bis 16 darstellbar. Dies erfolgt derart, daß hintereinander bei Vorliegen eines Zählerstandes 1 bis 8 je eine der acht Leitungen $L_{30}$ und bei Vorliegen eines Zählerstandes 9 bis 16 eine Leitung $L_{31}$ mit einem Abfragesignal beaufschlagt wird. Im Falle der Abfrage einer 8 mal 8 Matrix werden die acht Leitungen $L_{30}$ im Multiplexer 10 auf die ebenfalls acht Leitungen $L_{10}$ und damit die Reihen der Tastatur-Matrix durchgeschaltet. Dieser Durchschalt-Zustand entspricht der durchgezogenen Linie im Multiplexer 10. Die Leitungen $L_{31}$ gehen an den Demultiplexer 20. Im Falle der Abfrage einer 8 mal 8 Matrix werden sie nicht genutzt. Die acht Leitungen $L_{20}$ werden vom Multiplexer 20 an die acht Leitungen $L_{21}$ durchgeschaltet, die an den weiteren Multiplexer 50 geführt sind. An den Multiplexer 50 gehen ferner drei Leitungen $L_{41}$ vom Zähler 40, so daß nacheinander damit die acht ($= 2^3$) Spalten der Matrix, von denen je eine einer Leitung aus $L_{20}$ und $L_{21}$ zugeordnet ist, abgefragt werden. Dabei wird eine der Matrixleitungen einer Leitung aus dem Bus $L_{20}$ oder $L_{21}$ zugeordnet. Auf

der Leitung $L_{50}$ am Ausgang des Multiplexers 50 erscheint so ein vom Takt des Zählers 40 bestimmtes Signal, welches auf "aktiv" geht, wenn eine gedrückte Taste T adressiert ist. Wenn dies der Fall ist, wird der Zählerstand des Zählers 40, der über die Leitung $L_{42}$ an die Speicherschaltung 100 gelangt, in einem der Register 101, 102, 103 gespeichert. Der Zählerstand repräsentiert die bei der Abfrage gedrückte Taste T (Tastencode).

Sind mehr als drei Tasten gedrückt, dann wird vom Register 104, ebenfalls in der Speicherschaltung 100, eine Flagge gesetzt, die eine Fehlbedienung anzeigt. Weitere Flaggen können anzeigen, ob die Schalterstellung sich noch ändert (z.B. durch Prellen) oder ob alle Schalterstellungen stabil sind. Die Inhalte der Register gelangen an den Prozessor P, der die Information, die durch Schließen einer Taste vermittelt wird, weiterverarbeitet und gleichzeitig umgekehrt Anleitungen aufnimmt und an die Steuerschaltung 110 weiterleitet. Die Signale von den Spalten, die gerade abgefragt werden, gelangen über die Leitung $L_{22}$ an die Speichereinheit 100, um die Abfrage der Matrix 1 zu starten. Solange keine Taste gedrückt ist, wird die Matrix nicht abgefragt.

Soll nun eine Tastatur abgefragt werden, die eine **andere Konfiguration** als die einer 8 mal 8 Matrix hat, z.B. die einer 10 mal 2 Matrix, so wird die Schaltungseinrichtung wie folgt angepaßt: In dem Multiplexer 20 wird zwischen den Leitungen $L_{31}$, die vom Demultiplexer 30 her kommen, und den Leitungen $L_{20}$ eine Verbindung derart hergestellt, daß auf zwei der acht Leitungen $L_{20}$ der Informationsfluß - in Figur 1 - von links nach rechts stattfindet, also zwei der acht Leitungen $L_{20}$ zusätzlich zu den acht Leitungen $L_{10}$ zur Beaufschlagung von Reihen mit Abfragesignalen eingesetzt werden, während die sechs verbleibenden Leitungen $L_{20}$, auf denen der Informationsfluß von rechts nach links stattfindet, nach wie vor zur Abfrage der - jetzt nur noch sechs - Spalten eingesetzt werden. Insofern kann durch eine leitungsweise Umschaltung der Leitungen $L_{20}$ im Multiplexer 20 eine Anpassung an eine andere Konfiguration der Tastatur 1 vorgenommen werden. Der Multiplexer 20 kann also jede einzelne der acht Leitungen $L_{20}$ umschalten, und zwar

(a) entweder mit Informationsfluß von links nach rechts vom Demultiplexer 30 zu einer Reihe der Matrix ("Reihen"-Ausgang des Multiplexers 20)

(b) oder mit Informationsfluß von rechts nach links von einer Spalte der Matrix zum Multiplexer 50 ("Spalten"-Eingang des Multiplexers 20). Der Verlauf der Information erfolgt dann nicht mehr von rechts nach links als "Spalten-Ausgang", sondern von links nach rechts als "Reihen-Eingang". Insoweit gilt dann der gestrichelte, den Reihen als Eingang zugeordnete

Verlauf des Busses $L_{20}$.

Die Anpassung an eine Tastatur 1 mit der Konfiguration 10 mal 6 ist also dann erfolgt, wenn zusätzlich zu den acht Leitungen $L_{10}$ noch zwei Leitungen $L_{20}$ den Reihen der Matrix und nunmehr nur sechs Leitungen der Leitungen $L_{20}$ in umgekehrter Richtung den Spalten zugeordnet werden. Wegen dieser Umschaltmöglichkeit, die in der Matrix 20 durch die gestrichelte Verbindung der Leitungen $L_{31}$ und $L_{20}$ angedeutet ist, sind auch die Leitungen $L_{20}$ in Figur 1 mit großen breiten Pfeilen in beiden Richtungen (anders als die Leitungen $L_{10}$) versehen. Die gestrichelt gezeichnete Umschaltung kommt für 0 bis zusätzlich maximal 7 Leitungen (also insgesamt 15 Reihen der Matrix), die in durchgezogener Linie eingezeichnete Umschaltung kommt für höchstens 8 und mindestens 1 Leitung in Betracht.

Je nach Einstellung dieses zweiten Multiplexers 20 können also Tastaturen in der Konfiguration 9 mal 7, 10 mal 6, ..., usw. bis zu 15 mal 1 abgefragt werden (16 mal 0 wäre auch realisierbar, ist aber sinnlos). Die entsprechende Einstellung des Multiplexers 20 erfolgt von der Steuerschaltung 110 her über Leitung $L_{110}$ mit einem Auswahlsignal, mit dem die Anzahl der zusätzlichen Reihen angegeben wird.

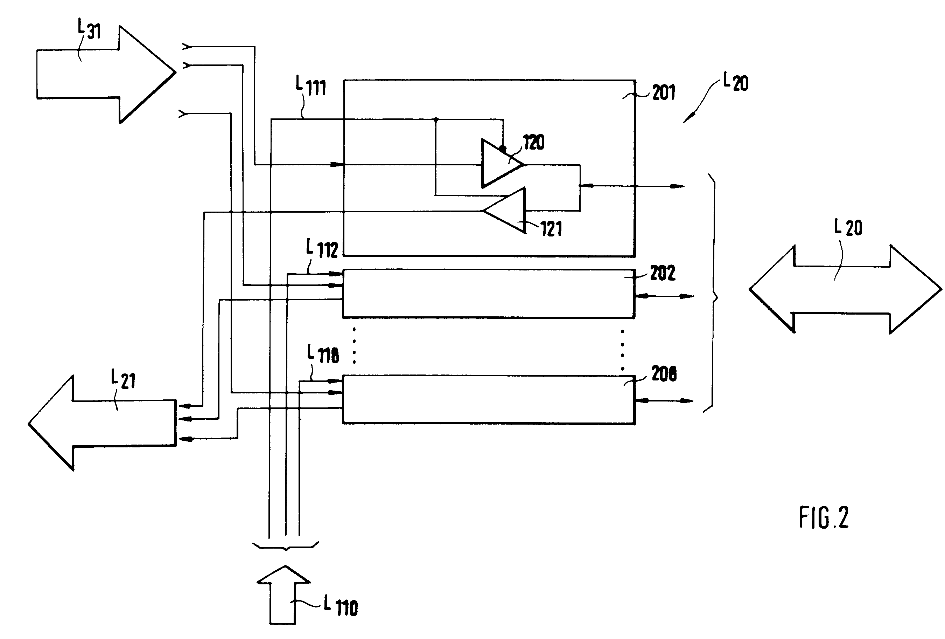

Figur 2 zeigt schematisch die hardwaremäßige Ausbildung des **Multiplexers 20**, der in acht Abschnitte 201, 202, ...208 aufgeteilt ist, an die die Steuerleitungen $L_{111}$, $L_{112}$, ..., $L_{118}$ von der Steuerschaltung 110 gelangen, die in ihrer Gesamtheit die Leitungen $L_{110}$ in Figur 1 bilden. Befindet sich das Steuersignal auf einer dieser Leitungen auf dem Wert 1, dann wird der Pufferverstärker 120 gesperrt und der Pufferverstärker 121 aktiviert. D.h., der Informationsfluß kann nur von rechts nach links, nämlich von einer der Leitungen $L_{20}$, d.h. einer Spalte her, zu einer der Leitungen $L_{21}$ und damit zum Multiplexer 50 erfolgen. Hat ein Steuersignal auf einer der Leitungen $L_{110}$ hingegen den Wert 0, dann erfolgt der Informationsfluß von links nach rechts, d.h. von einer der Leitungen $L_{30}$ zu einer der Leitungen $L_{20}$, die dann an eine Reihe der Tastatur 1 geht.

Soweit die Schaltung bis jetzt beschrieben worden ist, beruht sie also darauf, daß man sie an eine von einer Grundmatrix (im Beispiel 8 mal 8) abweichende Matrix dadurch adaptieren kann, **daß durch Einstellung des Multiplexers 20 Spaltenausgänge zu Reiheneingänge gemacht** werden. Voraussetzung dafür ist, daß der Demultiplexer 30 intern immer die maximal mögliche Zahl von Reiheneingängen der Matrix (= Schaltungsausgänge von 30) generiert, d.h. nicht nur die - im Beispiel - für die Grundmatrix erforderlichen acht Reiheneingänge, sondern stets die maximal erforderlichen 15 Reiheneingänge (bei 4 Eingängen auf $L_{43}$ sind 16

möglich). Dieser geringe Mehraufwand ist jedoch z.B. im ASIC nicht relevant. Er ermöglicht aber eine frei wählbare Matrixkonfiguration.

Das Ausführungsbeispiel nach Figur 1 - soweit bis jetzt beschrieben - ist in **einem erweiterten Mode** durch **Zuschaltung eines externen weiteren Demultiplexers 60** mit nur geringem Aufwand an eine Tastatur mit einer sehr viel **höheren Anzahl von Tasten** als sie der Grundmatrix der Schaltung entspricht, **adaptierbar**. Zu diesem Zweck wird der Multiplexer 10 so geschaltet, daß er (wie in Figur 1 gestrichelt gezeigt) seine Eingangssignale nicht mehr über die Leitung $L_{30}$ vom Demultiplexer 30 her erhält, sondern direkt vom Ausgang des Zählers 40 über die Leitung $L_{42}$. Auf den Leitungen $L_{10}$ erscheint jetzt anstatt des im Demultiplexer 30 demultiplexten Zählerstandes 1 aus 8 direkt der Zählerstand. Da in dem Beispiel, von dem Figur 1 ausgeht, von den acht Bits auf den 8 Leitungen $L_{40}$ bereits 3 Leitungen mit den niedrigsten 3 Bits für das Demultiplexen im Demultiplexer 50 benötigt werden, stehen für die Reihen noch 5 Bits auf 5 Leitungen $L_{42}$ zur Verfügung. Das entspricht einem Zählerstand von 1 bis 32 ($= 2^5$). Im Demultiplexer 60 werden daraus dann 32 den Reihen einer Matrix bei einer Abfrage je einzeln zuordenbare Ausgangssignale generiert. Bei Zuschaltung des Demultiplexers 60, der in Fig. 1 gestrichelt eingezeichnet ist, ergeben sich damit rechts desselben 32 Leitungen, die zur Abfrage von Reihen der Matrix eingesetzt werden können. Daneben stehen nach wie vor 8 Spalten zur Verfügung, so daß eine Tastatur mit maximal 32 mal 8 = 256 Tasten abgefragt werden kann. Der Demultiplexer 60 und seine aufgezeigte Schaltung stellen also eine einfache Möglichkeit der **externen Erweiterung** außerhalb der eigentlichen Schaltung dar. Die normale Betriebsart läuft also mit einer 1 aus 16 Demultiplexung im Demultiplexer 30, während bei der expandierten Betriebsart der - interne - Demultiplexer 30 durch Leitung $L_{42}$ überbrückt und der Zählerausgang dann im Demultiplexer 60 eine Demultiplexung 1 aus 32 stattfindet. Die Erweiterbarkeit ist also dadurch gegeben, daß der Demultiplexer 30 umgangen, direkt an den Ausgang geschaltet und extern durch einen erweitert arbeitenden Demultiplexer ersetzt werden kann.

Von den Leitungen am Ausgang des Multiplexers 60 bei expandierten Betrieb ist also immer nur eine auf 0 (aktiv), alle anderen auf 1 (inaktiv). Die Reihen werden nacheinander auf 0 geschaltet.

Die Umschaltung des Multiplexers 10 auf expandierten Betrieb (gestrichelt eingezeichnete Schalterstellung) erfolgt über die Steuerleitung 11, die von der Steuerschaltung 110 mit einem entsprechenden Steuersignal beaufschlagt wird. An den Multiplexer 10 gelangt ferner über die Leitung 12 ein Start/Stop-Signal, welches im Demultiplexer 60 benötigt wird, um zwischen Stop-Betrieb (keine Taste aktiv) und Start-Betrieb (Taste(n) aktiv) umzuschalten.

Der Zähler läuft im Betrieb immer von 1 bis 256, unabhängig von der Betriebsart (normal/expandiert) oder Matrix-Konfiguration (8 mal 8; 9 mal 7; usw.). Solange jedoch keine Taste betätigt wird, wird die Tastatur 1 nicht abgefragt. Es liegen alle Reihen gleichzeitig auf aktiven Pegel, d.h. haben den Wert 0. Wird nun eine Taste gedrückt, so geht die Spalte, in welcher die Taste liegt, auch auf aktiven Pegel. Diese Änderung gelangt über den Multiplexer 20 und Leitung $L_{22}$ an die Speichereinheit 100 und dient dazu, die Abfrageschaltung zu starten. Dann wird der Zähler 40 gestartet. Am Ende eines Zählzyklus erzeugt er ein Interrupt-Signal, das an den Prozessor gelangt und startet erneut, falls im letzten Scan-Zyklus mindestens eine Taste als gedrückt erkannt wurde.

Die Funktion des Demultiplexers 30 kann verallgemeinert wie folgt beschrieben werden. Der Demultiplexer 30 nimmt eine "1 aus (m + n)" Decodierung der $\log_2 (m + n)$ codierten Zählerausgänge des Zählers 40 vor. Es wird immer also nur eine von (m + n) Leitungen aktiviert. Es sind maximal (theoretisch) die 16 Leitungen $L_{30}$ und $L_{31}$. Mit (m + n) = 16 sind im Ausführungsbeispiel bei m, n = 8 die möglichen Konfigurationen der Matrix im Normal-Mode (d.h. ohne Expandierung durch Demultiplexer 60) abgedeckt. Von diesen (m + n) Signalen werden im Normal-Mode m als Ausgänge an die Reihen n ausgegeben. n stehen als Eingänge von den Spalten zur Verfügung. $\log_2 n$ Leitungen vom Ausgang des Zählers - im Ausführungsbeispiel 3 Leitungen $L_{41}$ - gehen zu dem Multiplexer 50, der immer eine der n Spalten an seinem Eingang (3 Leitungen $L_{41}$) an seinem Ausgang $L_{50}$ durchschaltet. Am Ausgang $L_{50}$ dieses Multiplexers 50 erscheint somit, wie oben bereits erläutert, das sich mit dem Takt des Zählers 40 ändernde serielle Signal, welches inaktiv ist, wenn gerade eine nicht gedrückte Taste abgefragt wird und auf aktiv geht, wenn gerade eine gedrückte Taste adressiert ist.

Immer dann, wenn das Signal auf Leitung $L_{50}$ aktiv ist, wird der Zustand des Abtastzählers in einem der Register 101, 102, 103 gespeichert und somit die Position der gedrückten Taste festgestellt. Wird im selben Scan-Zyklus eine weitere Taste als betätigt erkannt, so wird sie in einem weiteren der Register 101 bis 103 gespeichert. Maximal drei Tasten werden gespeichert. Bei mehr als drei Tasten wird davon ausgegangen, daß es sich um eine fehlerhafte Erkennung handelt. In diesem Fall wird eine "Error"-Flag gesetzt. Die Anzahl der betätigten Tasten wird ebenfalls in einem vom Prozessor P lesbaren Register gespeichert. Eine "Change"-Flag ist immer dann gesetzt, wenn sich von einem Scan-Zyklus zum nächsten entweder der Inhalt mindestens einem der drei Register 101 bis 103 oder die Anzahl der betätigten Tasten geändert hat. Somit kann erkannt werden, wann die Tastatur stabil ist, d.h. die Tasten nicht mehr prellen. Diese Flags, z.B. die "Change"-Flag, die vom Register 104 gesetzt wird, kann auch dazu dienen, daß "Interrupt"-Signal zu maskieren, d.h. es nur zu aktivieren, wenn eine "Change"-Flag nicht gesetzt und somit alle Tasten stabil sind. Da keine gesonderten Kontrolltasten (Shift/CONTROL) vorgesehen sind, können diese beliebig in der Matrix liegen, müssen aber vom Prozessor ausgewertet werden.

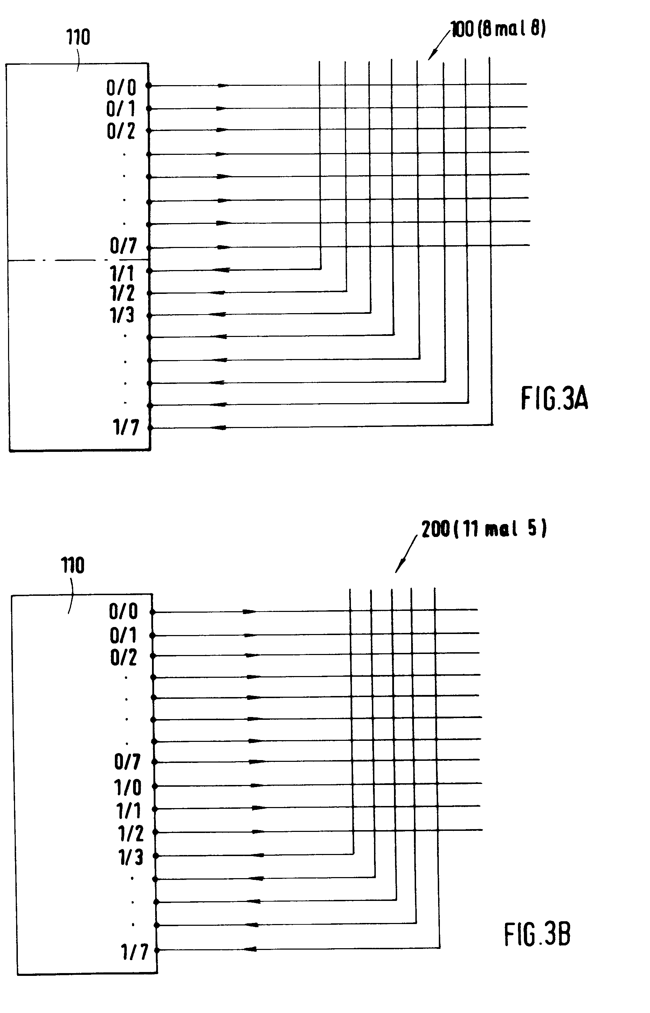

Die Erfindung läßt sich auch als Software bei Benutzung eines Mikroprozessors 110, der von dem Hauptprozessor P gesteuert wird, realisieren. Dies ist in den Figuren 3a und 3b dargestellt. Die Ports 0/0,0/1,...,0/7 sind als "Reihen-Ausgänge", d.h. als den Reihen der 8 mal 8 Matrix 100 zugeordnete Ausgänge geschaltet. Die weiteren acht Ports 1/1,1/2,...,1/7 sind als den einzelnen Spalten zugeordnete Eingänge, d.h. als "Spalten-Eingänge" des Mikroprozessors 110 geschaltet.

In Fig. 3b sind nun zur Ansteuerung einer (8 + 3) mal 5 Matrix zusätzlich zu den Ports 0/0,0/1,...,0/7 3 weitere Ports 1/0,1/1,1/2 des Mikroprozessors 110 als "Reihen-Ausgänge" umkonfiguriert, während lediglich die 5 Ports 1/3,...,1/7 als "Spalten-Eingänge" konfigurieren. Diese Umschaltbarkeit "als Eingang" oder "als Ausgang" ist bei Port Mikroprozessoren als softwaremäßig ansteuerbare Eigenschaft vorhanden. Der Mikroprozessor hat einen internen Zähler, der nacheinander (bei einer 8 x 8 Matrix) "1 aus 8" zählt und einen der 8 Reihenausgänge mit einem Signal beaufschlagt, dabei jeweils die Spalten abfragt und daraus die Zuordnung der gedrückten Taste zu einer Reihe und einer Spalte ermittelt.

Der Ablauf der Vorgänge der Software ist folgender:

(a) Die Ports 0/0,0/1,0/2,...,0/7 werden auf Ausgang (Reihen-Ausgang) gesetzt; und

(b) Die Matrix wird eingestellt, und zwar in dem **entweder**

(aa) alle Ports 1/0,1/1,1/2,...,1/7 auf Eingang (Spalten-Eingang) gesetzt (8 x 8 Matrix), **oder**

(bb) Fort 1/0 auf Ausgang, die Ports 1/1 bis 1/7 auf Eingang (9 x 7 Matrix), **oder**

(cc) Die Ports 1/0 und 1/1 auf Ausgang, die Ports 1/2 bis 1/7 auf Eingang gesetzt werden (10 x 6 Matrix), **oder**

(dd) Ports 1/0,1/1 und 1/2 auf Ausgang, die Ports 1/3 bis 1/3 auf Eingang (11 x 5 Matrix) **oder**

....., oder

....., usw.

(hh) Port 1/0 bis 1/6 auf Ausgang, Port 1/7 auf Eingang (15 x 1 Matrix) gesetzt werden.

Zur Erweiterung wird nun nicht mehr "1 aus 8" gezählt und entsprechend immer nur eine der 8 Ports mit einem Signal beaufschlagt, sondern es wird auf den zur Verfügung stehenden acht Leitungen binär der jeweilige Zählerstand ausgegeben, so daß auf den acht Leitungen theoretisch bis zu $2^8$ Werte dargestellt werden können. Da eine Leitung für ein Start/Stop-Signal verwendet wird, sind es aber nicht $2^8$, sondern - bei 8 Leitungen - $2^7$, also 128 Werte, die dann extern in einem zugeschalteten Demultiplexer einem aus maximal 128 Reihen-Ausgängen zugeordnet werden. Das Start/Stop-Signal steht auf der genannten einen Leitung an, sobald eine Taste gedrückt wird und setzt den dem Mikroprozessor eigenen oben genannten binären Zählablauf in Gang. Es werden also dann nach Auftreten des Start/Stop-Signals vom Mikroprozessor an den externen Demultiplexer nacheinander von 0 bis $2^7$ ansteigende binären Zählerwerte gegeben. Der externe Demultiplexer nimmt dann die eindeutige Zuordnung eines binären Zahlwertes zu einem seiner Reihen-Ausgänge vor. Am Mikroprozessor werden dann entsprechend einige oder alle der Ports 1/1,1/1,...,1/7 als Spalteneingänge bestimmt und je binärem Zählerwert abgefragt. Aus der Zuordnung einer bei Tastendruck aktivierten Spalte zu dem binären Zählwert, bei dessen zugeordneter Reihe die betreffende Spalte aktiviert war, wird softwaremäßig die gedrückte Taste bestimmt und abgespeichert.

**Patentansprüche**

1. Schaltungseinrichtung zur Abfrage einer Tastatur (1), die als Matrix in Form von Reihen und Spalten aufgebaut ist, und bei der die Reihen nacheinander mit einem Signal angesteuert werden, das bei gedrückter Taste (T) der Tastatur (1) an der zugehörigen Spalte ein Signal hervorruft, und bei der je Ansteuerung einer Reihe alle Spalten nacheinander abgefragt werden, **dadurch gekennzeichnet**, daß der Ausgang ($L_{40}$) eines Zählers (40), der zyklisch bis zu einem bestimmten Zählerstand zählt, in einem Demultiplexer (30) derart umgesetzt wird, daß zeitlich aufeinanderfolgend im Takt des Zählers eine bestimmte Anzahl (m + n) Signale zur Abfrage von Reihen der Matrix generiert werden, daß ein Teil (m) dieser Signale stets zur Ansteuerung einer gleichen Zahl von Reihen verwendet wird ($L_{30},L_{10}$), daß von den weiteren im Demultiplexer (30) generierten Signalen eine wählbar beliebige Zahl (1,2, ... (n-1)) über entsprechend einstellbare Abschnitte (201,202, ..., 208) einem Multiplexers (20) ebenfalls zur Ansteuerung von Reihen der Ma-trix verwendet ($L_{31},L_{20}$) werden, und daß über die verbleibenden Abschnitte des Multiplexers (20), die nicht zur Ansteuerung von Reihen der Matrix verwendet werden, die Spalten der Matrix an einen weiteren Multiplexer (50) durchgeschaltet ($L_{20},L_{21}$) werden, der, ebenfalls von Signalen am Ausgang ($L_{41}$) des Zählers (40) gesteuert, während des Anliegens eines Abfragesingals an einer Reihe, nacheinander im Takt des Zählers (40) die durchgeschalteten Spalten der Matrix abfragt.

2. Schaltungseinrichtung nach Anspruch 1, dadurch gekennzeichnet, daß die Abschnitte (201,202, ...208) des erstgenannten Multiplexers (20) zwei Puffer (120,121) aufweisen, die wahlweise einzeln für die Schaltrichtung von Demultiplexer (30) zu einer Reihe der Matrix oder für die Schaltrichtung von einer Spalte der Matrix zum Multiplexer (50) aktiviert werden können.

3. Schaltungseinrichtung nach Anspruch 1 oder 2, dadurch gekennzeichnet, daß unter Umgehung des genannten ersten Demultiplexers (30) eine bestimmte Anzal (5) der Bits am Ausgang des Zählers (40), die Zählerstände darstellen, über einen weiteren Multiplexer (10), der wahlweise die im erstgenannten Demultiplexer (30) generierten Signale oder direkt die von Zähler (40) abgegebenen Signale weiterleitet, an einen weiteren als externe Erweiterung geschalteten Demultiplexer (60) gelangen, der daraus den Zählerständen entsprechende Signale zur Abfrage von Reihen der Matrix generiert.

4. Schaltungsanordnung nach Anspruch 1 oder einem der folgenden, dadurch gekennzeichnet, daß bis zu 3 Tasten erkannt werden, und die Information über die Anzahl der erkannten Tasten sowie darüber, ob sich zwischen zwei Abfragezyklen noch Tasten verändern, in von einem Prozessor (P) lesbaren Flags abgelegt sind, und nach jedem Abfragezyklus ein Interruptsignal erzeugt und an den Prozessor (P) geleitet wird, das wahlweise mit dem Zustand des die Veränderung anzeigenden Flags maskiert werden kann.

5. Schaltungseinrichtung zur Abfrage einer Tastatur (1), die als Matrix in Form von Reihen und Spalten aufgebaut ist, und bei der die Reihen nacheinander mit einem Signal angesteuert werden, das bei gedrückter Taste (T) der Tastatur an der zugehörigen Spalte ein Signal hervorruft, und bei der je Ansteuerung einer Reihe alle Spalten nacheinander abgefragt werden, dadurch gekennzeichnet, daß ein von einem Haupt-Prozessor gesteuerter Mikroprozessor (110) zyklisch bis zu einem bestimmten Zählerstand zählt, und daß den zeitlich aufeinanderfolgend auftretenden Zählerständen Ports (0/0,0/1...0/7;1/1,1/2,...1/7) des Mikroprozessors zugeordnet sind, und daß ein Teil (0/0,0/1...0/7) der Ports stets als Reihen-Ausgänge zur Ansteuerung einer gleichen Zahl von Reihen der Matrix verwendet wird, und daß von den weiteren Ports (1/1,1/2,...1/) je nach gewünschter Konfiguration der Matrix eine wählbar beliebige Anzahl als weitere Reihen-Ausgänge zur Ansteuerung weiterer Reihen der Matrix verwendet werden, und daß die verbleibenden Ports, die nicht zur Ansteuerung von Reihen der Matrix verwendet werden, als Spalten-Eingänge den Spalten der Matrix zugeordnet und während des Anliegens eines Signals an einer Reihe abgefragt werden.

6. Schaltungseinrichtung nach Anspruch 5, dadurch gekennzeichnet, daß die Zuordnung von Reihen der Tastatur zu den Zählerständen im Mikroprozessor durch einen extern zugeschalteten Demultiplexer (60) erfolgt.

FIG.1

FIG.2

FIG.3A

FIG.3B